# EUROPÄISCHE PATENTSCHRIFT

(11) **EP 2 583 464 B1**
(45) Veröffentlichungstag und Bekanntmachung des Hinweises auf die Patenterteilung: **17.07.2019**
(21) Anmeldenummer: 11733816.0
(22) Anmeldetag: 14.06.2011
(51) Int. Cl.: H04N 9/04, H04N 5/355, H01L 27/146

(54) **FARBBILDSENSOR**
COLOR IMAGE SENSOR
CAPTEUR D'IMAGE COULEUR

(30) Priorität: 15.06.2010 DE 102010030108
(43) Veröffentlichungstag der Anmeldung: 24.04.2013
(73) Patentinhaber: Fraunhofer-Gesellschaft zur Förderung der angewandten Forschung e.V., 80686 München (DE)
(72) Erfinder: SCHMID, Michael, 91058 Erlangen (DE); GICK, Stephan, 96179 Rattelsdorf (DE)
(74) Vertreter: Stöckeler, Ferdinand
(86) Internationale Anmeldenummer: PCT/EP2011/059820
(87) Internationale Veröffentlichungsnummer: WO 2011/157696

(56) Entgegenhaltungen:
- US-A- 5 335 013
- US-A1- 2006 274 189
- US-B1- 6 388 709

## Beschreibung

Die vorliegende Erfindung bezieht sich auf einen Farbbildsensor mit einer Mehrzahl von Sensorelementen und zugeordneten Filtern.

Bei der Herstellung bzw. Fertigung von Farbbildsensoren, die sowohl im Bereich der Consumer-Elektronik, im industriellen Umfeld, im Bereich der Medizintechnik als auch im Bereich Kino und Fernsehen zum Einsatz kommen, werden vorwiegend CMOS-Bildsensoren verbaut, deren Bildpunkte (Pixel) mit einzelnen oder flächigen Farbfiltern, vorwiegend rot, grün und blau, versehen werden. Anschließend sind die Farbfilter in ihren Eigenschaften nicht mehr veränderlich.

Bekannte Farbbildsensoren besitzen unveränderliche Farbfilter und weisen eine Mehrzahl von Sensorelementen (Pixel) auf, die auf einem Substrat angeordnet sind. Jedes Sensorelement (Pixel) ist mit einem Farbfilter versehen, wobei die Farbfilter der Mehrzahl von Sensorelementen angeordnet sein können, um eine Bayer-Filtermaske zu bilden. Die Bayer-Filtermaske besteht zur hälfte (50 %) aus grünen, zu einem viertel (25 %) aus roten und zu einem viertel (25 %) aus blauen Farbfiltern. Die Verteilung der Farbfilter berücksichtigt die höhere Empfindlichkeit des menschlichen Auges gegenüber grünen Farbtönen. Weitere Beispiele von Farbbildsensoren können der DE 69 712 969 T2, der DE 69 131 076 T2, der DE 69 316 261 T2 und der DE 69 626 970 T2 entnommen werden. Bei den dort gezeigten Farbbildsensoren steht jedem Bildpunkt (Pixel) des Farbbildsensors jeweils nur ein Farbwert zur Verfügung. Die beiden fehlenden Farbinformationen müssen durch Interpolation mit Hilfe der benachbarten Bildpunkte (Pixel) ermittel werden. Die Hauptschwierigkeit besteht nun darin, geeignete Interpolationsalgorithmen zu finden, die zum einen realisierbar und zum anderen bis zur Auflösungsgrenze hin, z. B. Kanten akkurat erkennen und rekonstruieren können.

Für die Auswertung der Daten existiert eine hohe Anzahl an möglichen Verfahren. Beispiele sind der DE 69 729 648 T2, der DE 102 006 038 646 A1, der DE 69 922 129 T2 und der DE 102 006 013 810 B4 zu entnehmen. Ferner zielt die Anwendung geeigneter Interpolationsalgorithmen darauf ab, fehlerhafte Bildpunkte (Pixel) zu korrigieren sowie Kanten akkurat zu erkennen und zu rekonstruieren. Dies ist beispielsweise in der DE 102 006 050 864 und der DE 69 801 978 T2 beschrieben. Ferner existieren Bildwidergabegeräte mit mehrschichtigen LCD-Filtern, die für alle drei Primärfarben (Rot, Grün und Blau) ein Einstellen der Transmission erlauben, wie in der US 5686931 beschrieben ist.

Ein weiteres zur Zeit verwendetes Verfahren basiert auf der Nutzung mehrerer (vorwiegend drei) Sensorelemente zusammen mit einem Strahlteiler und unterschiedlichen flächigen Farbfiltern (vorwiegend rot, grün und blau) vor jeweils einem Sensorelement. Diese Ausführungsvariante liefert für jeden Bildpunkt (Pixel) alle benötigten Farbinformationen. Allerdings ist diese Ausführungsvariante aufwendig, teuer und benötigt viel Platz. Ferner erschweren optische Probleme, die durch den Strahlteiler verursacht werden, den Einsatz. Beispielsweise kann der Strahlteiler eine chromatische Aberration hervorrufen.

Bedingt durch Herstellungstoleranzen und Prozesse wie Alterung und Wärmeeinwirkung können sich die Eigenschaften der einzelnen Bildpunkte (Pixel) des Farbbildsensors ändern. Insbesondere bei qualitativ hochwertigen Farbbildsensoren für Film und Fernsehen ist es wünschenswert, diesen Effekt zu kompensieren. Eine Kalibrierung ist jedoch häufig sehr aufwendig, da der Farbbildsensor zunächst mit unterschiedliche hellen und gleichmäßigen ausgeleuchteten Bildern belichtet werden muss. Aus den aufgenommenen Bilder lassen sich Korrekturwerte für Verstärkung, Offset und Linearisierung für jeden einzelnen Bildpunkt (Pixel) errechnen. Um zu jeder Zeit eine bestmögliche Qualität des Farbbildsensors zu gewährleisten, müssten die Kamerabenutzer in der Lage sein, vor Ort eine Neukalibrierung durchzuführen. Da aber für eine Kalibrierung eine exakte Ausleuchtung mehrerer unterschiedlicher Aufnahmen und verschiedene manuelle Eingriffe nötig sind, wird eine Neukalibrierung in der Regel vermieden. Der Aufwand und das Risiko unbrauchbarer Aufnahmen nach einer fehlerhaften Neukalibrierung sind zu hoch.

Ein weiteres Problem bei der Verwendung von digitalen Bildsensoren ist der begrenzte Dynamikumfang. Derzeit versuchen Bildsensor-Hersteller mit verschiedenen Techniken den Dynamikumfang der Bildsensoren zu erweitern, was aber in der Regel mit Kompromissen verbunden ist. Entweder führen die angewandten Verfahren zu zeitlicher oder zu örtlicher Unschärfe.

Die US 2006/0274189 A1 zeigt einen Bildsensor und ein Verfahren zur Herstellung des Bildsensors. Der Bildsensor weist ein Array von Pixelzellen und zumindest ein MEMS-Element (MEMS = microelectromechanical system, dt. Mikrosystem) mit einer photonischen Kristallstruktur auf, wobei das MEMS-Element über zumindest einer der Pixelzellen angeordnet ist, um ansprechend auf zumindest eine angelegte Spannung selektiv zu ermöglichen, dass elektromagnetische Strahlung mit einer vorgegebenen Wellenlänge die Pixelzelle erreicht.

Die US 6,388,709 B1 zeigt ein Bildaufnahmegerät mit einem optischen Modulationselement bestehend aus elektrochromen Elementen für R, G und B, dessen spektrale Transmissionseigenschaften unabhängig gesteuert werden können. Durch Steuerung der spektralen Transmissionseigenschaften jeder Schicht des optischen Modulationselements, kann sichtbares Licht in R, G und B Wellenlängenbereichen zu unterschiedlichen Zeiten auf einen photoelektrischen Wandler des Bildaufnahmegeräts fallen.

Die US 5,355,013 zeigt ein Verfahren und eine Vorrichtung zum Simulieren einer Filmbildsequenz mit einer Videokamera.

Der vorliegenden Erfindung liegt die Aufgabe zugrunde, einen Farbbildsensor zu schaffen, der eine verbesserte Bildqualität sowie einen höheren Dynamikumfang liefern kann, ohne komplexe Interpolationsalgorithmen zu benötigen.

Diese Aufgabe wird durch einen Farbbildsensor gemäß Anspruch 1 gelöst.

Die Erfindung schafft einen Farbbildsensor mit einer Mehrzahl von Sensorelementen, die in einem zweidimensionalen Array angeordnet sind, wobei die Sensorelemente jeweils ein optisches Filter aufweisen, deren Transmissionsverhalten elektrisch einstellbar ist, und wobei der Farbbildsensor eine Steuerung zum Steuern der optischen Filter aufweist, wobei das Transmissionsverhalten der optischen Filter wellenlängenselektiv elektrisch einstellbar ist; wobei die Steuerung ausgelegt ist, um die optischen Filter so zu steuern, dass während des Betriebs ein definierbarer Wellenlängenbereich priorisiert wird; und wobei die Steuerung ausgelegt ist, um zusammenhängende Gebiete von Sensorelementen, die Licht in einem Wellenlängenbereich erfassen, durch die Aufnahme eines Bildes mit nicht priorisierten Wellenlängenbereichen zu erkennen, wobei die Steuerung ausgelegt ist, um die optischen Filter in diesem Gebiet zu steuern, um den Wellenlängenbereich durch eine Erhöhung der Anzahl der im erfassten Wellenlängenbereich selektiven Sensorelemente in den zusammenhängenden Gebieten zu priorisieren, ein Bild mit priorisierten Filtern aufzunehmen und die beiden aufgenommenen Bilder zu addieren.

Bei Ausführungsbeispielen der Erfindung ist jedes Sensorelement des Farbbildsensors mit einem variablen und dynamisch konfigurierbaren optischen Filter versehen, dessen Transmissionsverhalten elektrisch einstellbar ist, um z. B. die Empfindlichkeit des Farbbildsensors der Belichtungssituation anzupassen. Ferner ist bei Ausführungsbeispielen der Erfindung das Transmissionsverhalten der optischen Filter wellenlängenselektiv elektrisch einstellbar, um z. B. festzulegen welche Wellenlängen (Farbanteile) mit welcher Transmission zum jeweiligen Sensorelement durchgelassen werden. Diese Einstellungen können für jedes Sensorelement unterschiedlich und zeitlich variabel vorgenommen werden. Hierdurch wird beispielsweise der Einsatz einer, von Bild zu Bild veränderlichen Farbmatrix (Farbfiltermaske) ermöglicht. Somit ist es möglich, Einfluss auf die Charakteristik des Farbbildsensors zu nehmen, bevor das durch die Sensorelemente erfasste Bild in elektrische Signale gewandelt wird, und das fortlaufend während des Betriebs und individuell für jeden Bildpunkt (Pixel).

Ausführungsbeispiele der vorliegenden Erfindung werden nachfolgend unter Bezugnahme auf die beiliegenden Zeichnungen näher erläutert. Es zeigen:
- Fig. 1: eine schematische Seitenansicht eines Ausführungsbeispiels eines erfindungsgemäßen Farbbildsensors;
- Fig. 2: zeigt eine schematische Seitenansicht eines alternativen Ausführungsbeispiels eines erfindungsgemäßen Farbbildsensors;
- Fig. 3a: zeigen den Farbbildsensor aus Fig. 1, wobei die in einem zweidimensionalen
- und 3b: Array angeordneten optischen Filter von der Steuerung so gesteuert werden, dass eine variable Bayer-Filtermaske entsteht.

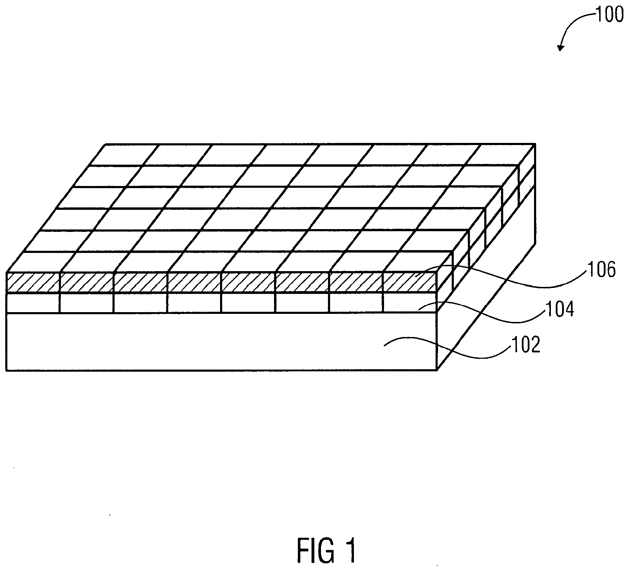

Fig. 1 zeigt eine schematische Seitenansicht eines Ausführungsbeispiels eines erfindungsgemäßen Farbbildsensors 100. Auf einem Substrat 102 ist eine Mehrzahl von Sensorelementen 104 in einem zweidimensionalen Array angeordnet. Jedes Sensorelement 104 ist mit einem optischen Filter 106 versehen, dessen Transmissionsverhalten elektrisch einstellbar ist. Ferner kann der optische Filter so ausgeführt sein, dass das Transmissionsverhalten wellenlängenselektiv elektrisch einstellbar ist. Die Sensorelemente 104 können beispielsweise als CMOS-Bildsensoren ausgeführt sein, während die optischen Filter beispielsweise auf der LCD-Technologie basieren können. Die Steuerung zum Steuern der optischen Filter 106 kann beispielsweise in das Substrat 102 integriert werden, wobei eine Durchkontaktierung zur Kontaktierung der optischen Filter 106 mit der Steuerung verwendet werden kann.

Neben der Verwendung von optischen Filtern basierend auf LCD-Modulen, beispielsweise von Modulen für LCD-Projektoren, die in der Regel mit hochtransparenten Silikonharzen und mit einer speziellen Technik zur blasenfreien Verklebung direkt auf die Sensorelemente aufgeklebt werden, besteht die Möglichkeit, die einzelnen Bildpunkte (Pixel) eines LCD-Moduls (Schadt-Helfrich-Zelle) und die Steuerung (Ansteuerelektronik) direkt auf die Sensoroberfläche aufzubringen. Hierbei ist es von Vorteil, die Farbfilter bei der Herstellung der Bildsensoren, ohne besondere zusätzliche Verfahrensschritte, direkt auf die Silizium-Dies aufzubringen. Ferner ist eine Realisierung mit Hilfe der Mikrosystemtechnik, wie z.B. mit Mikrospiegeln, denkbar. Ferner können die optischen Filter direkt auf dem Halbleiter aufgebracht werden. Möglich wird dies durch die Ausnutzung elektrooptischer Effekte in Halbleiter wie z. B. den Franz-Keldysh-Effekt oder den Quantum-Stark-Effekt (QCSE). Alternative Implementierungen von elektrisch steuerbaren Filtern sind Fachleuten auf dem Gebiet der Optoelektronik bekannt.

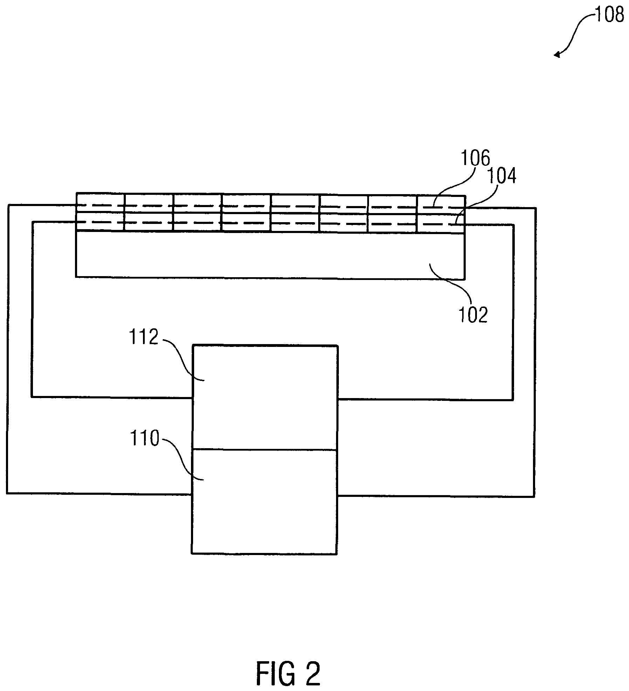

Fig. 2 zeigt eine schematische Seitenansicht eines alternativen Ausführungsbeispiels eines erfindungsgemäßen Farbbildsensors 108 ähnlich dem in Fig. 1 gezeigten, wobei die Steuerung 110 zum Steuern der optischen Filter 106 und die elektronische Schaltung 112 zum Auslesen der Sensorelemente 104 schematisch dargestellt sind. Die Steuerung kann bei Ausführungsbeispielen zumindest teilweise in das Substrat integriert sein oder extern ausgeführt sein. Die Steuerung 110 der optischen Filter 106 kann ausgeführt sein, beispielsweise zu entscheiden, ob die Farbmatrix von Bild zu Bild geändert wird, ob die Transmission des optischen Filters 106 bei einem überbelichteten Sensorelement 104 reduziert wird, oder ob aus zwei nachfolgenden Bildern mit unterschiedlichen Farbfiltermasken mehr Originalwerte zur Berechnung des Gesamtbildes genutzt werden.

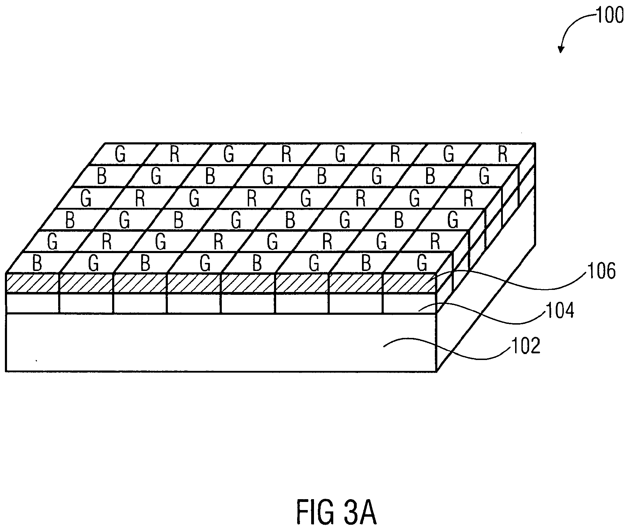

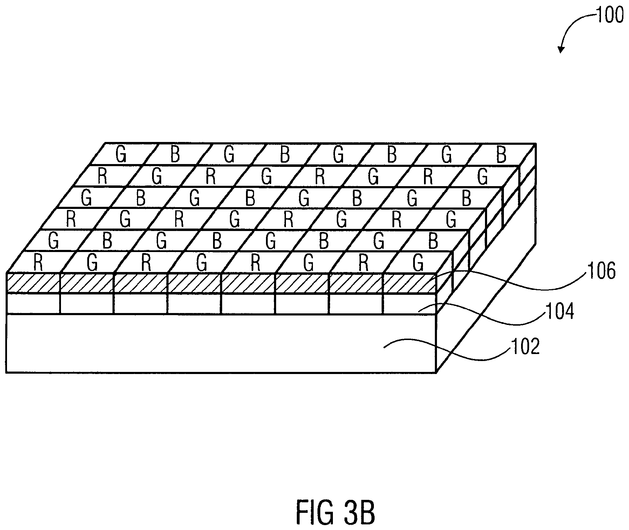

Fig. 3a und 3b zeigen den Farbbildsensor 100 aus Fig. 1, wobei die in einem zweidimensionalen Array angeordneten optischen Filter 106 von der Steuerung so gesteuert werden, dass eine variable Bayer-Filtermaske entsteht. Die in Fig. 3a gezeigte Bayer-Filtermaske kann beispielsweise für die Erfassung eines ersten Bildes genutzt werden, während für die Erfassung eines zweiten Bildes eine, gemäß Fig. 3b, veränderte Bayerfiltermaske genutzt werden kann. Dadurch, dass sich die Bayer-Filtermaske von Bild zu Bild veränderlich ist oder als Zufallsmuster konfigurierbar ist oder in fester Abfolge darstellbar ist (z. B. in zweier/dreier-Folge mit zweifacher/dreifacher Framerate), folgt eine volle Farbbesetzung jedes Bildpunkts (Pixel), was zu einer einfachen nachfolgenden Filterung und Vermeidung regelmäßiger Strukturen führt. Somit können durch den Einsatz einer flexiblen Farbfiltermaske die Aufbereitungsalgorithmen wesentlich bessere Ergebnisse erzielen.

Im Bereich der szenischen Film- und Kinoproduktion wünschen sich die Kameramänner bzw. Filmemacher, dass digitale Bildsensoren einen ähnlichen Bildeindruck vermitteln wie die klassische Filmrolle. Insbesondere das Filmkorn der klassischen Filmrolle sollte nachbildbar sein. Der erfindungsgemäße Farbbildsensor ermöglicht eine Emulation des Filmkorns durch z. B. eine Variation der Farbfiltermaske.

Die Anwendungsgebiete für Farbbildsensoren mit einer variablen Farbfiltermaske sind sehr vielseitig. Der Einsatz des erfindungsgemäßen Farbbildsensors erlaubt Verbesserungen der Bildqualität in allen Bereichen. Insbesondere im Bereich der industriellen Kamerasysteme, bei Film- und Fernsehkameras und Spezialapplikationen wie Raumfahrt oder Automotive kann der erfindungsgemäße Farbbildsensor zu signifikanten Verbesserungen verhelfen und teilweise einen Einsatz überhaupt erst ermöglichen.

Eine einstellbare Transmission des optischen Filters ermöglicht es, den Dynamikbereich des Farbbildsensors wesentlich zu erhöhen. Die Filterstärke kann z. B. bei überbelichteten Bildpunkten (Pixeln) angehoben und bei unterbelichteten Bildpunkten (Pixeln) abgesenkt werden. Die Gesamthelligkeit ergibt sich aus der Summe aus Filterstärke und Pixelhelligkeit (Gesamthelligkeit = Filterstärke + Pixelhelligkeit). Bei einer Filterauflösung von z. B. 8 Bit ist eine Erweiterung des Dynamikbereich um 4 Bit durchaus möglich. Dadurch sind Bildsensoren möglich, die zur Objekterkennung in Fahrzeugen verwendet werden können und auch bei Licht, Gegenlicht, Dunkelheit oder Nebel zusammen mit schnellen Bewegungen, noch eine sichere Erkennung gewährleisten. Da der erfindungsgemäße Farbbildsensor ohne bewegte mechanische Komponenten funktioniert, ist er klein, robust und kostengünstig.

Ferner kann die Farbfiltermaske des erfindungsgemäßen Farbbildsensors dynamisch angepasst werden, z. B. kann die Wellenlängenselektivität des optischen Filters bei blauen Flächen zu Blau und bei roten Flächen zu Rot verschoben werden. Anwendung findet dieser Vorteil z. B. in der Medizintechnik. Insbesondere bei Endoskopen, müssen die Farbbildsensoren im Bereich der Hautfarben und Rottöne dem untersuchenden Arzt für eine sichere Diagnose maximalen Detailreichtum in den Bildern bieten, wobei natürlich alle anderen Farben immer noch korrekt dargestellt werden müssen. Hier kann eine adaptive Farbfiltermaske helfen, der Situation entsprechend, besonders Rottöne zu priorisieren. Dazu bietet sich folgender Ansatz an: Es wird zunächst ein Bild mit einer gleichverteilten Rot/Grün/Blau-Farbfiltermaske aufgenommen. Im Anschluss daran wird die Farbfiltermaske zum nächsten Bild hin, entsprechend den im ersten Bild gewonnenen Erkenntnissen, angepasst. Innerhalb von Flächen mit Rottönen kann die Wellenlängenselektivität des optischen Filters, im zweiten Bild hin, zu mehr roten Bildpunkten (Pixel) verschoben werden. In Summe entsteht aus den beiden Bildern ein detailreiches Farbbild mit besonders feiner Abstufung der Rottöne. Auch eine adaptive Anpassung der Transmission würde enorm helfen, bei einer schwierigen Beleuchtungssituation den Dynamikbereich zu erhöhen und damit den Arzt bei einer Beurteilung des Bildmaterials unterstützen.

Ferner ermöglicht der variable optische Filter des erfindungsgemäßen Farbbildsensors eine automatische Kalibration der Bildpunkte (Pixel). Bei demontiertem Objektiv kann die einfallende Lichtmenge automatisch eingestellt werden und somit die nötigen Bilder unterschiedlicher Helligkeit aufgenommen werden. Im Normalbetrieb kann der optische Filter des erfindungsgemäßen Farbbildsensors wieder die Rot/Grün/Blau-Farbmatrix updaten und bei schwierigen Beleuchtungssituationen den Dynamikbereich vergrößern.

Ferner bietet der Einsatz von variablen und dynamisch konfigurierbaren optischen Filtern Verbesserungen bezüglich des Weißabgleichs und der einfacheren Erkennung und Rekonstruierung von Kanten. Ferner ist der Einsatz von Sekundärfarben (Magenta, Cyan, Gelb) sowie Weiß/Schwarz in der Filtermaske des erfindungsgemäßen Farbbildsensors möglich. Die Beispiele für Applikationen lassen sich immer weiter fortführen von den bereits erwähnten Bereichen Automotive, Film und Fernsehen, Medizintechnik über Raumfahrt, autonome Systeme, Sicherheitstechnik hin zu Multimedia, Spiele und Consumer-Elektronik. Die Technik lässt sich auch auf andere Märkte und weitere Applikationen ausweiten, insbesondere wenn der Bedarf nach einer Verbesserung der Bildqualität oder des Dynamikumfangs erforderlich ist oder den Einsatz einer Kamera überhaupt erst ermöglichen.

Bei weiteren Ausführungsbeispielen kann der Farbbildsensor eine Mehrzahl von Sensorelementen aufweisen, die in einem zweidimensionalen Array angeordnet sind, wobei die Sensorelemente jeweils ein optisches Filter aufweisen, deren Transmissionsverhalten elektrisch einstellbar ist, und wobei der Farbbildsensor eine Steuerung zum Steuern der optischen Filter aufweist.

Bei den weiteren Ausführungsbeispielen kann das Transmissionsverhalten der optischen Filter wellenlängenselektiv elektrisch einstellbar sein.

Bei den weiteren Ausführungsbeispielen kann die Steuerung ausgelegt sein, um die optischen Filter so einzustellen, dass sie eine Farbmatrix bilden.

Bei den weiteren Ausführungsbeispielen kann die Steuerung ausgelegt sein, um die Farbmatrix von einem erfassten Bild zum nächsten erfassten Bild zu verändern.

Bei den weiteren Ausführungsbeispielen kann die Farbmatrix eine Bayer-Filtermaske bilden.

Bei den weiteren Ausführungsbeispielen können die optischen Filter einen einstellbaren Transmissionskoeffizienten aufweisen.

Bei den weiteren Ausführungsbeispielen kann der Farbbildsensor eine Steuerung aufweisen, die ausgelegt ist, um den Transmissionskoeffizienten bei überbelichteten Sensorelementen herab zusetzen und/oder bei unterbelichteten Sensorelementen hinauf zu setzen.

Bei den weiteren Ausführungsbeispielen kann die Steuerung ausgelegt sein, um die optischen Filter so zu steuern, dass während des Betriebs ein definierbarer Wellenlängenbereich priorisiert wird.

Bei den weiteren Ausführungsbeispielen kann die Steuerung ausgelegt sein, um bei einem erfassten Bild die optischen Filter zu steuern, um den definierten Wellenlängenbereich durchzulassen und bei einem nächsten erfassten Bild die optischen Filter zumindest teilweise zu steuern, um andere Wellenlängenbereiche durchzulassen.

Bei den weiteren Ausführungsbeispielen kann die Steuerung ausgelegt sein, um zusammenhängende Gebiete von Sensorelementen, die Licht in einem Wellenlängenbereich erfassen, zu erkennen, wobei die Steuerung ausgelegt ist, um die optischen Filter in diesem Gebiet zu steuern, um den Wellenlängenbereich zu priorisieren.

Bei den weiteren Ausführungsbeispielen kann die Steuerung ausgelegt sein, um die optischen Filter zu steuern, um einen Filmkorn zu emulieren.

Bei den weiteren Ausführungsbeispielen kann das Transmissionsverhalten des oder der optischen Filter so einstellbar sein, dass die Primärfarben rot, grün, und blau, dass die Sekundärfarben Magenta, Cyan und Gelb, Mischfarben oder dass Weiß/Schwarz durchgelassen werden.

Bei den weiteren Ausführungsbeispielen kann die Steuerung ausgebildet sein, um die optischen Filter basierend auf Kalibrierungsdaten, die bei demontiertem Objektiv aufgenommen wurden, zu steuern.

## Patentansprüche

1. Farbbildsensor (100;108) mit einer Mehrzahl von Sensorelementen (104), die in einem zweidimensionalen Array angeordnet sind, wobei die Sensorelemente (104) jeweils ein optisches Filter (106) aufweisen, deren Transmissionsverhalten basierend auf einem elektrooptischen Effekt elektrisch einstellbar ist, und wobei der Farbbildsensor eine Steuerung (110) zum Steuern der optischen Filter (106) aufweist
wobei das Transmissionsverhalten der optischen Filter wellenlängenselektiv elektrisch einstellbar ist;
wobei die Steuerung (110) ausgelegt ist, um die optischen Filter (106) so zu steuern, dass während des Betriebs ein definierbarer Wellenlängenbereich priorisiert wird; **dadurch gekennzeichnet, dass** die Steuerung (110) ausgelegt ist, um zusammenhängende Gebiete von Sensorelementen (106), die Licht in einem Wellenlängenbereich erfassen, durch die Aufnahme eines Bildes mit gleichverteilten Wellenlängenbereichen zu erkennen, wobei die Steuerung (110) ausgelegt ist, um die optischen Filter (106) in diesem Gebiet zu steuern, um den Wellenlängenbereich zu priorisieren, indem innerhalb des zusammenhängenden Gebiets von Sensorelementen das Transmissionsverhalten der optischen Filter einer Anzahl von Sensorelementen wellenlängenselektiv zu dem erfassten Wellenlängenbereich hin verschoben wird, um ein Bild mit priorisiertem Wellenlängenbereich aufzunehmen.

2. Farbbildsensor (100;108) nach Anspruch 1, bei dem die Steuerung (110) ausgelegt ist, um die optischen Filter (106) so einzustellen, dass sie eine Farbmatrix bilden.

3. Farbbildsensor (100;108) nach Anspruch 2, bei dem die Steuerung (110) ausgelegt ist, um die Farbmatrix von einem erfassten Bild zum nächsten erfassten Bild zu verändern.

4. Farbbildsensor (100; 108) nach einem der Ansprüche 2 oder 3, bei dem die Farbmatrix eine Bayer-Filtermaske bildet.

5. Farbbildsensor (100;108) nach einem der Ansprüche 1 bis 4, bei dem die optischen Filter (106) einen einstellbaren Transmissionskoeffizienten aufweisen.

6. Farbbildsensor (100;108) nach Anspruch 5, der eine Steuerung (110) aufweist, die ausgelegt ist, um den Transmissionskoeffizienten bei überbelichteten Sensorelementen herab zusetzen und/oder bei unterbelichteten Sensorelementen hinauf zu setzen.

7. Farbbildsensor (100;108) nach einem der Ansprüche 1 bis 6, bei dem die Steuerung (110) ausgelegt ist, um bei einem erfassten Bild die optischen Filter (106) zu steuern, um den definierten Wellenlängenbereich durchzulassen und bei einem nächsten erfassten Bild die optischen Filter (106) zumindest teilweise zu steuern, um andere Wellenlängenbereiche durchzulassen.

8. Farbbildsensor (100;108) nach einem der Ansprüche 2 bis 7, bei dem die Steuerung ausgelegt ist, die optischen Filter zu steuern, um durch eine Variation der Farbfiltermaske einen Filmkorn zu emulieren.

9. Farbbildsensor (100; 108) nach einem der Ansprüche 1 bis 8, bei dem das Transmissionsverhalten des oder der optischen Filter so einstellbar ist, dass die Primärfarben rot, grün, und blau, dass die Sekundärfarben Magenta, Cyan und Gelb, Mischfarben oder dass Weiß/Schwarz durchgelassen wird.

10. Farbbildsensor (100; 108) nach einem der Ansprüche 1 bis 9, bei dem die Steuerung ausgebildet ist, um die optischen Filter basierend auf Kalibrierungsdaten, die bei demontiertem Objektiv aufgenommen wurden, zu steuern.

## Claims

1. Color image sensor (100; 108) comprising a plurality of sensor elements (104) arranged in a two-dimensional array, wherein the sensor elements (104) each comprise an optical filter (106) whose transmission behavior is electrically adjustable based on an electro-optical effect, and wherein the color image sensor comprises a control (110) for controlling the optical filters (106),
wherein the transmission behavior of the optical filters is electrically adjustable in a wavelength-selective manner,
wherein the control (110) is implemented to control the optical filters (106) such that a definable wavelength range is prioritized during operation;
**characterized in that**
the control (110) is implemented to recognize contiguous areas of sensor elements (106) sensing light in a wavelength range, by capturing an image with equally distributed wavelength ranges, wherein the control (110) is implemented to control the optical filters (106) in this area in order to prioritize the wavelength range by wavelength-selectively shifting, within the contiguous area of sensor elements, the transmission behavior of the optical filters of a number of sensor elements towards the sensed wavelength range in order to capture an image with prioritized wavelength range.

2. Color image sensor (100; 108) according to claim 1, wherein the control (110) is implemented to adjust the optical filters (106) such that the same form a color matrix.

3. Color image sensor (100; 108) according to claim 2, wherein the control (110) is implemented to change the color matrix from one captured image to the next captured image.

4. Color image sensor (100; 108) according to one of claim 2 or 3, wherein the color matrix forms a Bayer filter mask.

5. Color image sensor (100; 108) according to any one of claims 1 to 4, wherein the optical filters (106) comprise an adjustable transmission coefficient.

6. Color image sensor (100; 108) according to claim 5 comprising a control (110) that is implemented to reduce the transmission coefficient in overexposed sensor elements and/or to increase the same in underexposed sensor elements.

7. Color image sensor (100; 108) according to any one of claims 1 to 6, wherein the control (106) is implemented to control the optical filters (106) in a captured image in order to allow the defined wavelength range to pass and to at least partly control the optical filters (106) in a next captured image to allow other wavelength ranges to pass.

8. Color image sensor (100; 108) according to any one of claims 2 to 7, wherein the control is implemented to control the optical filters to emulate a film grain by a variation of the color filter mask.

9. Color image sensor (100; 108) according to any one of claims 1 to 8, wherein the transmission behavior of the optical filter(s) is adjustable such that the primary colors red, green, blue, the secondary colors magenta, cyan and yellow, mixed colors or white/black are allowed to pass.

10. Color image sensor (100; 108) according to any one of claims 1 to 9, wherein the control is implemented to control the optical filters based on calibration data captured with dismantled objective.

## Revendications

1. Capteur d'image couleur (100; 108) avec une pluralité d'éléments capteurs (104) qui sont disposés en un réseau bidimensionnel, dans lequel les éléments capteurs (104) présentent, chacun, un filtre optique (106) dont le comportement de transmission est réglable électriquement sur base d'un effet électro-optique, et dans lequel le capteur d'image couleur présente une commande (110) destinée à commander les filtres optiques (106);
dans lequel le comportement de transmission des filtres optiques est réglable électriquement de manière sélective en longueur d'onde;
dans lequel la commande (110) est conçue pour commander les filtres optiques (106) de sorte que soit priorisée, pendant le fonctionnement, une plage de longueurs d'onde pouvant être définie;
**caractérisé par le fait que**
la commande (110) est conçue pour détecter des zones contiguës d'éléments détecteurs (106) qui détectent la lumière dans une plage de longueurs d'onde en capturant une image à plages de longueurs d'onde réparties uniformément, où la commande (110) est conçue pour commander les filtres optiques (106) dans cette zone pour prioriser la plage de longueurs d'onde en déplaçant, dans la zone contiguë d'éléments capteurs, le comportement de transmission des filtres optiques d'un nombre d'éléments capteurs de manière sélective en longueur d'onde vers la plage détectée pour capturer une image à plage de longueurs d'onde priorisée.

2. Capteur d'image couleur (100; 108) selon la revendication 1, dans lequel la commande (110) est conçue pour régler les filtres optiques (106) de sorte qu'ils forment une matrice de couleur.

3. Capteur d'image couleur (100; 108) selon la revendication 2, dans lequel la commande (110) est conçue pour changer la matrice de couleur d'une image capturée à l'image capturée suivante.

4. Capteur d'image couleur (100; 108) selon l'une des revendications 2 ou 3, dans lequel la matrice de couleur forme un masque de filtre de Bayer.

5. Capteur d'image couleur (100; 108) selon l'une des revendications 1 à 4, dans lequel les filtres optiques (106) présentent un coefficient de transmission réglable.

6. Capteur d'image couleur (100; 108) selon la revendication 5, présentant une commande (110) qui est conçue pour diminuer le coefficient de transmission pour les éléments capteurs surexposés et/ou pour augmenter ce dernier pour les éléments capteurs sous-exposés.

7. Capteur d'image couleur (100; 108) selon l'une des revendications 1 à 6, dans lequel la commande (110) est conçue pour commander les filtres optiques (106) pour une image capturée pour laisser passer la plage de longueurs d'onde définie et pour commander au moins partiellement les filtres optiques (106) pour une image capturée suivante pour laisser passer d'autres plages de longueurs d'onde.

8. Capteur d'image couleur (100; 108) selon l'une des revendications 2 à 7, dans lequel la commande est conçue pour commander les filtres optiques pour émuler un grain de film par une variation du masque de filtre couleur.

9. Capteur d'image couleur (100, 108) selon l'une des revendications 1 à 8, dans lequel le comportement de transmission du ou des filtres optiques est réglable de sorte qu'ils laissent passer les couleurs primaires rouge, vert et bleu, les couleurs secondaires magenta, cyan et jaune, les couleurs mélangées ou le blanc/noir.

10. Capteur d'image couleur (100; 108) selon l'une des revendications 1 à 9, dans lequel la commande est conçue pour commander les filtres optiques sur base des données d'étalonnage qui ont été saisies à objectif démonté.
